# EUROPEAN PATENT SPECIFICATION

(11) **EP 2 544 236 B1**
(45) Date of publication and mention of the grant of the patent: **27.09.2017**
(21) Application number: 11750303.7
(22) Date of filing: 03.02.2011
(51) Int. Cl.: H01L 27/12, H01L 21/66, H01L 21/762

(54) **METHOD FOR PRODUCING AN SOI WAFER**
VERFAHREN ZUR HERSTELLUNG EINES SOI-WAFERS
PROCÉDÉ DE PRODUCTION DE PLAQUETTE DE SILICIUM SUR ISOLANT

(30) Priority: 04.03.2010 JP 2010047897
(43) Date of publication of application: 09.01.2013
(73) Proprietor: Shin-Etsu Handotai Co., Ltd., Tokyo (JP)
(72) Inventor: KUWABARA, Susumu, Chiyoda-ku, Tokyo (JP)
(74) Representative: Wibbelmann, Jobst
(86) International application number: PCT/JP2011/000607
(87) International publication number: WO 2011/108189

(56) References cited:
- JP-A- 5 275 665
- JP-A- 2000 195 791
- JP-A- 2002 343 842
- JP-A- 2006 080 461
- JP-A- 2007 521 660
- US-A1- 2004 130 718
- US-A1- 2010 007 872
- US-B1- 6 428 894

## Description

### TECHNICAL FIELD

The present invention relates to a method for manufacturing an SOI wafer having an SOI layer formed on a buried insulator layer, and more particularly to a method for designing and manufacturing an SOI wafer being used in a device fabrication process or an inspection process in which position control, such as handling, position detection, positioning, and automatic focusing, of an SOI wafer is implemented using reflected light from the SOI wafer.

### BACKGROUND ART

In recent years, SOI wafers have been used in device fabrication as semiconductor substrates having a multilayer film structure. For example, various devices, such as CPUs, logics, memories, physical sensors related to MEMS (Micro-Electro-Mechanical-Systems), biosensors, and RF devices, are fabricated by using SOI wafers.

As methods for fabricating the SOI wafers, wafer bonding methods and a SIMOX method are generally known. An ion implantation delamination method (also referred to as the SMART-CUT (a registered trademark) method), which is one of the wafer bonding methods, is proposed in Patent Document 1. In this method, an oxide film is formed on at least one of two silicon wafers, at least one of hydrogen ions and rare gas ions are implanted into a main surface of one of the wafers (a bond wafer) to form an ion-implanted layer in the interior of the wafer. The ion-implanted surface is then brought into close contact with a main surface of the other silicon wafer through the oxide film and the resultant wafer is then delaminated at the ion-implanted layer by performing a heat treatment at a temperature in the range of 300°C to 600°C, or more than that. The ion implantation delamination method has an advantage in that an SOI wafer having a thin SOI layer with a film thickness uniformity of ±10 nm or less can be readily fabricated and an advantage in that the delaminated bond wafer can be reused several times to reduce cost.

On the other hand, in the SIMOX method, high concentration oxygen ions are implanted into the interior of a silicon wafer to form an oxygen ion-implanted layer, a buried oxide film (a BOX layer) is then formed in the silicon wafer by performing an annealing process at a high temperature of approximately 1300°C, and a layer of its surface side is used as the SOI layer.

In device fabrication processes using the SOI wafers fabricated in the above manner, presence or absence of an SOI wafer is detected when handling the wafer, and position control such as positioning in a z-axis direction is implemented with an automatic focusing mechanism to adjust a pattern on the SOI wafer. Reflected light from the surface of the SOI wafer when the SOI wafer is irradiated with light is utilized for the position control.

For example, an automatic focus adjustment function using the reflected light from the surface is used in automatic focusing control for positioning of the SOI wafer before exposure and in control of adjusting a distance between a projection lens and the SOI wafer upon exposure in a photolithography operation. The reflected light is also utilized for position control in various other processes (e.g., inspection processes and bonding processes), such as the position detection and the positioning. In inspection processes of the SOI wafers, intensity of the reflected light from the SOI wafer surface is used to keep distances between the wafer and a probe constant and determine an accurate position in the wafer so that the position can be inspected. The inspection processes include device pattern inspection, defect inspection, impurity inspection, electrification inspection, surface roughness inspection, and work function inspection.

### CITATION LIST

### PATENT LITERATURE

Patent Document 1: Japanese Unexamined Patent publication (Kokai) No.H05-211128

US 2004/0130718 A1 concerns a system for performing single wavelength ellipsometry on a thin film on a multi-layer substrate. In this regard, a method of controlling the position of a silicon-on-insulator (SOI) substrate is disclosed which uses reflectance properties of the SOI substrate at a specific wavelength λ.

US 2010/0007872 A1 concerns a surface inspecting method and device.

US 6,428,894 B1 relates to tunable and removable plasma deposited antireflective coatings.

### SUMMARY OF INVENTION

However, in the position control of the SOI wafer, utilizing the reflected light, implemented in device fabrication processes or inspection processes using the SOI wafers, there has been a problem in that the reflection rate of irradiation light varies widely due to variation in the SOI layer thickness in a plane of the SOI wafer and the intensity of the reflected light thereby varies so that the above-described position control of the SOI wafer cannot be implemented accurately. In addition, mechanisms such as the above automatic focusing and positioning mechanisms used in device fabrication processes using bulk silicon (silicon single crystal) wafers cannot be used without being altered in the device fabrication processes using the SOI wafers, and other mechanisms are needed to be prepared.

The present invention was accomplished in view of the above-described problems, and an object of the present invention is to provide a method for manufacturing an SOI wafer that enable the variation in the reflection rate of light due to the variation in the SOI layer thickness in a plane of the SOI wafer to be inhibited, thereby improving precision of the SOI-wafer position control. Another object of the present invention is to provide a method for manufacturing an SOI wafer that enable cost reduction by sharing position control mechanisms used in device fabrication processes or inspection processes using bulk silicon wafers.

The present invention provides a method for manufacturing an SOI wafer having an SOI layer formed on a buried insulator layer, the SOI wafer being to be used in a device fabrication process or an inspection process including a process of controlling a position of the SOI wafer on the basis of intensity of reflected light from the SOI wafer when the SOI wafer is irradiated with light having a wavelength λ, the method comprising the steps of: setting the wavelength λ to be used for controlling the position of the SOI wafer, designing a thickness of the buried insulator layer of the SOI wafer, on the basis of said wavelength λ of the light for use in the process of controlling the position, by an expression d= (1/2) x (λ/n) xA, wherein d represents the thickness of the buried insulator layer, n represents a refractive index of the buried insulator layer, and A represents an arbitrary positive integer, the process being to be implemented on the SOI wafer after manufacturing; and fabricating the SOI wafer having the SOI layer formed on the buried insulator layer having the designed thickness.

With the manufacturing method including the steps of: designing the thickness of the buried insulator layer of the SOI wafer on the basis of the wavelength λ of the light for use in the process of controlling the position that is to be implemented on the SOI wafer after manufacturing; and fabricating the SOI wafer having the SOI layer formed on the buried insulator layer having the designed thickness, an SOI wafer can be manufactured which enables inhibition of the variation in the reflection rate of the light due to the variation in the SOI layer thickness and hence improvement of the precision of the position control when controlling the position of the SOI wafer. In addition, the reflection rate for the manufactured SOI wafer can be made to be equivalent to that for a bulk silicon. Therefore, the manufactured SOI wafer enables sharing of position control mechanisms used in the device fabrication process and the inspection process using a bulk silicon wafer to reduce cost in the device fabrication process and the inspection process.

In the method, the thickness of the buried insulator layer of the SOI wafer can be designed as a thickness d satisfying an expression d=(1/2)×(λ/n)×A, wherein d represents the thickness of the buried insulator layer, n represents a refractive index of the buried insulator layer, and A represents an arbitrary positive integer.

When the thickness of the buried insulator layer of the SOI wafer is designed as a thickness d satisfying an expression d=(1/2)×(λ/n)×A, wherein d represents the thickness of the buried insulator layer, n represents a refractive index of the buried insulator layer, and A represents an arbitrary positive integer as above, the thickness of the buried insulator layer of the SOI wafer can be concretely designed on the basis of the wavelength λ of the light for use in the position control, and the SOI wafer can be manufactured which enables effective inhibition of the variation in the reflection rate of the light due to the variation in the SOI layer thickness when controlling the position of the SOI wafer.

In the method, the buried insulator layer can be any one of a silicon oxide film, a silicon nitride film, and a silicon oxynitride film, or a laminated insulator layer formed as a multilayer thereof.

Even when various insulator films, such as any one of a silicon oxide film, a silicon nitride film, and a silicon oxynitride film, or a laminated insulator layer formed as a multilayer thereof, are used as the buried insulator layer, the SOI wafer can be manufactured which enables inhibition of the variation in the reflection rate of the light due to the variation in the SOI layer thickness when controlling the position in accordance with the present invention.

In the method, visible light is preferably used as the light with which the SOI wafer is irradiated.

Using inexpensive visible light as the light with which the SOI wafer is irradiated is preferable because this enables cost reduction in the device fabrication process and the inspection process.

An aspect of the present invention is a method for manufacturing an SOI wafer that is to be used in the device fabrication process or the inspection process including a process of controlling a position of the SOI wafer on the basis of intensity of reflected light from the SOI wafer when the SOI wafer is irradiated with light having a wavelength λ. This method includes the steps of: designing a thickness of the buried insulator layer of the SOI wafer on the basis of the wavelength λ of the light for use in the process of controlling the position that is implemented on the SOI wafer after manufacturing; and fabricating the SOI wafer having the SOI layer formed on the buried insulator layer having the designed thickness. The method can therefore manufacture an SOI wafer that enables inhibition of the variation in the reflection rate of the light due to the variation in the SOI layer thickness and hence improvement of the precision of the position control when controlling the position of the SOI wafer, such as position detection, positioning, and automatic focusing. In addition, the SOI wafer manufactured in the above manner can make the reflection rate equivalent to that in a state where a bulk silicon is irradiated with the light having the wavelength λ and enables use of position control mechanisms used in the device fabrication process or the inspection process using a bulk silicon wafer. As a result, the cost can be reduced in the device fabrication process and the inspection process.

### BRIEF DESCRIPTION OF DRAWINGS

FIG. 1 is a diagram showing the result of a simulation of a relation among the SOI layer thickness, the buried insulator layer thickness, and the reflection rate;
FIG. 2 is a diagram showing the result of a simulation of the reflection rate with respect to the variation in an SOI layer thickness in the range from 2000 to 4000 nm when being irradiated with light having a wavelength λ of 633 nm;
FIG. 3 is a diagram showing the results of Example and Comparative Example;
FIG. 4 is a diagram showing the result of a simulation of the reflection rate with respect to the variation in an SOI layer thickness of not less than 4000 nm when being irradiated with light having a wavelength λ of 633 nm;
FIG. 5 is a diagram showing the result of a simulation of a relation among the wavelength, the SOI layer thickness, and the reflection rate; and
FIG. 6 is a schematic view showing an example of an SOI wafer being designed and manufactured by the method for designing and manufacturing an SOI wafer of the present invention.

### DESCRIPTION OF EMBODIMENTS

Hereinafter, embodiments of the present invention will be described, but the present invention is not limited to these embodiments.

Conventionally, in the SOI-wafer position control utilizing the reflected light, such as position detection, positioning, and z-axis positioning by automatic focusing, implemented in device fabrication processes or inspection processes using the SOI wafers, there has been a problem in that the reflection rate of irradiation light varies widely due to the variation in the SOI layer thickness in a plane of the SOI wafer and the intensity of the reflected light thereby varies. This affects the SOI-wafer position control such that the position control cannot be implemented accurately. In addition, mechanisms such as the above-described automatic focusing and positioning mechanisms used in device fabrication processes and inspection processes using bulk silicon wafers cannot be used without being altered in the device fabrication processes and inspection processes using the SOI wafers, and other mechanisms are therefore needed to be prepared.

In view of this, the present inventor repeatedly and keenly conducted studies to solve the problem. The present inventor focused attention on the wavelength of light for use in the position control and the thickness of the buried insulator layer and simulated the relation between the SOI layer thickness and the reflection rate of light when the wavelength and the buried insulator layer thickness are changed.

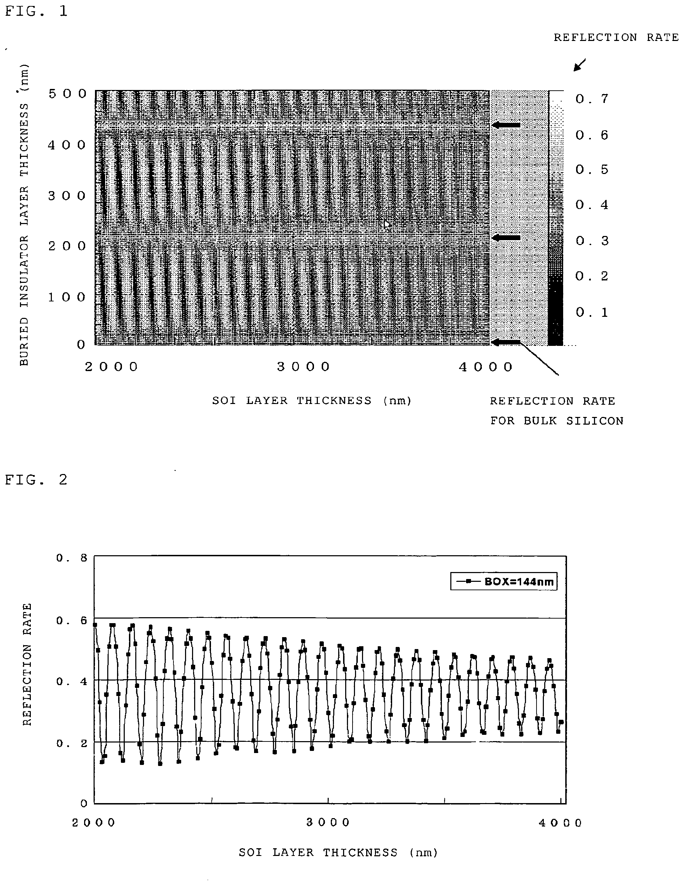

FIG. 1 shows the result of the simulation of the relation between the reflection rate of light and the SOI layer thickness when SOI wafers each having a different buried insulator layer thickness are irradiated with a HeNe laser having a wavelength λ of 633 nm. The variation in the reflection rate is represented by a shade of color in FIG. 1 and a color closer to white exhibits a higher reflection rate. Here, the buried insulator layer is a silicon oxide film (a BOX film), and its refractive index is 1.46.

It can be seen from the relation among the buried insulator layer thickness, the SOI layer thickness, and the reflection rate in FIG. 1 that the reflection rate does not vary (the color exhibiting the reflection rate does not vary) with respect to the variation in the SOI layer thickness when the buried insulator layer thickness is approximately 217 nm and 434 nm.

This value of the reflection rate is equivalent to a reflection rate in a state where the buried insulator layer thickness is zero, i.e., in a state where a bulk silicon is used (See arrows in FIG. 1).

FIG. 2 shows the result of the simulation of the reflection rate with respect to the variation in an SOI layer thickness in the range from 2000 to 4000 nm when an SOI wafer having a buried insulator layer of a 144-nm thickness silicon oxide film is irradiated with the HeNe laser having a wavelength λ of 633 nm.

As shown in FIG. 2, the reflection rate varies widely due to the variation in the SOI layer thickness. In the position control implemented on the SOI wafer with the HeNe laser, when there is thickness distribution in the plane of the SOI layer, there arises a problem in that, according to the buried insulator layer thickness, variation in reflected-light intensity, i.e., insufficient reflected-light intensity or excessive reflected-light intensity may occur with respect to a position in the plane of the SOI layer, thereby increasing an error of the position control.

The present inventor thought on the basis of these results that selecting a film thickness that is properly designed for the wavelength λ of light for use in the SOI-wafer position control as the thickness of the buried insulator layer of the SOI wafer enables the variation in the reflection rate to be avoided even though the SOI layer thickness varies, thereby bringing the present invention to completion.

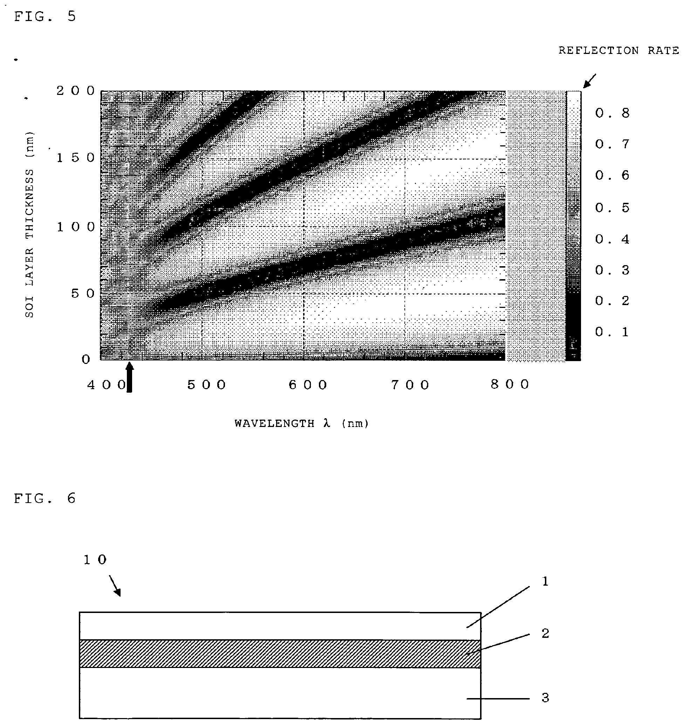

FIG. 6 shows a schematic view of an example of the SOI wafer being designed and manufactured by the method for designing an SOI wafer and the method for manufacturing an SOI wafer of the present invention. As shown in FIG. 6, in the SOI wafer 10, the SOI layer 1 is formed on the buried insulator layer 2 on the base wafer 3, which is a supporting substrate.

In order to design an SOI wafer being used in the device fabrication process or the inspection process including the process of controlling the position of the SOI wafer with light having a wavelength λ, such as position detection, positioning, and focusing, in the method for designing an SOI wafer of the present invention, the thickness of the buried insulator layer of the SOI wafer is designed on the basis of the wavelength λ of the light such that the variation in the reflection rate due to the variation in the SOI layer thickness is inhibited.

More specifically, the buried insulator layer thickness can be designed as a thickness d satisfying an expression d=(1/2)×(λ/n)×A, wherein d represents the thickness of the buried insulator layer, n represents the refractive index of the buried insulator layer, and A represents an arbitrary positive integer.

Designing the thickness of the buried insulator layer of the SOI wafer in this manner realizes design of the SOI wafer that enables inhibition of the variation in the reflection rate of the light due to the variation in the SOI layer thickness, that is, inhibition of the variation in the intensity of the reflected light due to the variation in the SOI layer thickness when the SOI-wafer position control is implemented. The designed SOI wafer therefore enables improvement of the precision of the SOI-wafer position control, such as position detection, positioning, and automatic focusing, thereby ensuring reliable position control.

Also, when the SOI wafer designed in the above manner is used, the reflection rate can be made to be equivalent to a reflection rate in a state where a bulk silicon (or a bulk silicon on which a film identical to that formed on the SOI surface is formed) is irradiated with the light having the wavelength λ. As a result, with designed the SOI wafer, mechanisms, such as the automatic focusing and positioning mechanisms, used in the device fabrication process and inspection process using a bulk silicon wafer can be used in SOI-wafer position control without being altered. The designed SOI wafer also enables cost reduction in the device fabrication process and the inspection process using the SOI wafer.

In the method, the buried insulator layer can be any one of a silicon oxide film, a silicon nitride film, and a silicon oxynitride film, or a laminated insulator layer formed as a multilayer thereof.

When the buried insulator layer is the silicon nitride film or silicon oxynitride film as above, the buried insulator layer thickness may be designed by using the refractive index of the buried insulator layer as well as the silicon oxide film.

In the case of the laminated insulator layer formed of a plurality of buried insulator layers, the thicknesses of the buried insulator layers may be each designed such that the product (dxn) of the buried insulator layer thickness and its refractive index is calculated at each buried insulator layer in the laminated insulator layer and the sum of the products of all layers satisfies the expression (1/2)×λ×A. For example, when the laminated insulator layer has two layers, it may be designed so as to satisfy an expression d1×n1+d2×n2=(1/2)×λ×A, wherein d1 and n1 represent the thickness and refractive index of a first buried insulator layer respectively and d2 and n2 represent the thickness and refractive index of a second buried insulator layer respectively.

Even when various buried insulator layers are used as described above, the present invention realizes design of an SOI wafer by which the variation in the reflection rate of the light due to the variation in the SOI layer thickness can be inhibited when controlling the position of the SOI wafer in the device fabrication process and the inspection process.

When the SOI wafer is designed such that inexpensive visible light will be used as the light for use in the SOI wafer position control, the SOI wafer that enables cost reduction in the device fabrication process and the inspection process can be obtained.

Next, the method for manufacturing an SOI wafer of the present invention will be described.

First, the thickness of the buried insulator layer of the SOI wafer is designed on the basis of the wavelength λ of light for use in the SOI-wafer position control that is to be implemented on the SOI wafer after manufacturing such that the variation in the reflection rate due to the variation in the SOI layer thickness is inhibited, in the same manner as the above-described method for designing an SOI wafer of the present invention.

More specifically, the buried insulator layer thickness can be designed as a thickness d satisfying the expression d=(1/2)×(λ/n)×A, wherein d represents the thickness of the buried insulator layer, n represents the refractive index of the buried insulator layer, and A represents an arbitrary positive integer.

Next, the SOI wafer 10 having the SOI layer 1 formed on the buried insulator layer 2 on the base wafer 3, which is a supporting substrate, is fabricated as shown in FIG. 6. In the fabrication, the thickness of the buried insulator layer 2 is the designed thickness.

The SOI wafer 10 can be fabricated, for example, by the bonding method in which two silicon single crystal wafers are prepared for the base wafer 3 and the bond wafer, the buried insulator layer 2 having the above designed thickness is formed on at least one of the wafers, the base wafer 3 is bonded to the bond wafer, and the bond wafer is thinned.

The thinning step for forming the SOI layer 1 of the SOI wafer 10 can be performed by grinding and polishing, or the ion implantation delamination method. The ion implantation delamination method is a technique for obtaining an SOI wafer, for example, as follows: a silicon oxide film is formed on at least one of two silicon single crystal wafers; at least one of hydrogen ions and rare gas ions are implanted from the surface of one of the wafers (the bond wafer) to form a micro bubble layer (an enclosed layer) at the close vicinity of the surface in the interior of the bond wafer; the ion-implanted surface of the bond wafer is then brought into close contact with the other wafer (the base wafer) through the silicon oxide film; a heat treatment (a delamination heat treatment) is then performed to delaminate the bond wafer as a thin film such that the micro bubble layer becomes a cleavage plane (a delaminated plane); and a heat treatment (a bonding heat treatment) is further performed to firmly bond the two silicon single crystal wafers together. An SOI wafer having a thin SOI layer with very high thickness uniformity can be obtained with relative ease by the ion implantation delamination method.

Various heat treatments may be then applied according to the SOI wafer being fabricated.

Manufacturing the SOI wafer in this manner realizes manufacture of the SOI wafer that enables inhibition of the variation in the reflection rate of the light due to the variation in the SOI layer thickness, that is, inhibition of the variation in the intensity of the reflected light due to the variation in the SOI layer thickness when the SOI-wafer position control, such as position detection, positioning, and automatic focusing is implemented in the device fabrication process and the inspection process. The designed SOI wafer therefore enables improvement of the precision of the SOI-wafer position control, thereby ensuring reliable position control.

Also, when the SOI wafer manufactured in the above manner is used, the reflection rate can be made to be equivalent to a reflection rate in a state where a bulk silicon is irradiated with the light having the wavelength λ. As a result, with the manufactured SOI wafer, mechanisms, such as the automatic focusing and positioning mechanisms, used in the device fabrication process and the inspection process using a bulk silicon wafer can be used without being altered in the SOI-wafer position control. The manufactured SOI wafer also enables cost reduction in the device fabrication process and the inspection process using the SOI wafer.

In the method, the buried insulator layer can be any one of a silicon oxide film, a silicon nitride film, and a silicon oxynitride film, or a laminated insulator layer formed as a multilayer thereof.

When the buried insulator layer is the silicon nitride film or silicon oxynitride film as above, the buried insulator layer thickness may be designed by using the refractive index of the buried insulator layer as well as the silicon oxide film.

In the case of the laminated insulator layer formed of a plurality of buried insulator layers, as described above, the thicknesses of the buried insulator layers may be each designed such that the product (dxn) of the buried insulator layer thickness and its refractive index is calculated at each buried insulator layer in the laminated insulator layer and the sum of the products of all layers satisfies the expression (1/2)×λ×A.

Even when various buried insulator layers are used as described above, the present invention realizes manufacture of an SOI wafer by which the variation in the reflection rate of the light due to the variation in the SOI layer thickness can be inhibited when controlling the position of the SOI wafer.

When the SOI wafer is manufactured such that inexpensive visible light will be used as the light for use in the SOI-wafer position control, the SOI wafer that enables cost reduction in the device fabrication process and the inspection process can be obtained. Also, when position control of an SOI wafer with the surface on which a photosensitizer for photolithography is applied is implemented in the device fabrication process, exposure of a resist can be avoided by use of low-energy visible light as the irradiation light.

On the other hand, when the buried insulator layer thickness has been determined, a wavelength λ satisfying the expression d=(1/2)×λ×A is selected as a control wavelength λ for use in focusing, position detection, and the like in the SOI-wafer position control. By this method, the variation in the reflection rate due to the variation in the SOI layer thickness can be inhibited and the reflection rate can be made to be equivalent to that for a bulk silicon, similarly with the above description.

FIG. 5 is a diagram showing the result of the simulation of the relation among the wavelength λ, the SOI layer thickness, and the reflection rate when the buried insulator layer thickness is 145 nm. In the simulation, the buried insulator layer is a silicon oxide film, and its refractive index n is 1.46. As shown in FIG. 5, it can be seen that the variation in the reflection rate due to the variation in the SOI layer thickness is substantially eliminated when the wavelength λ is approximately 426 nm, which satisfies the expression d=(1/2)×λ×A. Accordingly, light having a wavelength λ of 426 nm can be used for the position control of the SOI wafer with the buried insulator layer having a thickness of 145 nm.

In the embodiments described above, the silicon oxide film, the silicon nitride film, and the silicon oxynitride film are exemplified as the buried insulator layer 2. In the present invention, however, insulator films made of high permittivity materials (high-k films) such as HfO₂, ZrO₂, La₂O₃, and TiO₂ can also be employed.

The present invention will be more specifically described below with reference to Example and Comparative Example, but the present invention is not limited this example.

### (Example)

The method for designing an SOI wafer and the method for manufacturing an SOI wafer of the present invention were applied to design and manufacture an SOI wafer being subjected to a photolithography operation in the device fabrication process, in which automatic focusing control was implemented utilizing light having a wavelength λ, for positioning of the SOI wafer before exposure. The wavelength λ of the light used herein was 633 nm. The thickness d of the buried insulator layer (the BOX layer) was designed to be 217 nm, which satisfies the expression d=(1/2)×λ×A, and the SOI wafer was manufactured. The reflection rate of the light when the manufactured SOI wafer was irradiated with the light having a wavelength λ of 633 nm was evaluated.

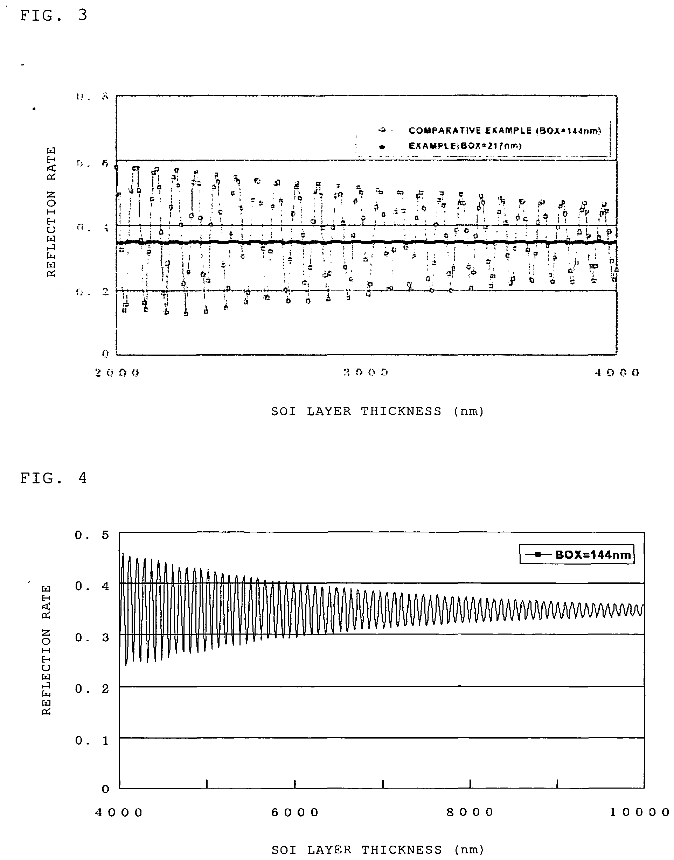

The evaluation result is given in FIG. 3. Referring to FIG. 3, it can be seen that the reflection rate with respect to the variation in the SOI layer thickness did not vary but stayed constant. This constant reflection rate was 0.35, which was equivalent to that when a bulk silicon was irradiated with the light having the wavelength λ. On the other hand, it can be seen that, in the later-described Comparative Example, the reflection rate with respect to the variation in the SOI layer thickness varied widely.

The automatic focusing control was then implemented on the manufactured SOI wafer in the photolithography operation. As a result, the automatic focusing control can be implemented with high precision. At this point in time, an automatic focusing mechanism for use in a bulk silicon can be employed without being altered.

It can be accordingly confirmed that the method for designing an SOI wafer and the method for manufacturing an SOI wafer of the present invention realize design and manufacture of the SOI wafer that enables the inhibition of the variation in the reflection rate of light due to the variation in the SOI layer thickness and hence the position control with improved precision when controlling the position of the SOI wafer. The designed and manufactured SOI wafer also enables cost reduction by sharing the position control mechanisms used in the device fabrication process and the inspection process using a bulk silicon wafer.

### (Comparative Example)

An SOI wafer was manufactured in the same manner as Example except that the thickness d of the BOX layer was designed to be a thickness of 144 nm not satisfying the expression d=(1/2)×(λ/n)×A, and the reflection rate was evaluated in the same manner as Example.

The result is given in FIG. 3. Referring to FIG. 3, it can be seen that the reflection rate varies from 0.12 to 0.58 at its maximum in the range between an SOI layer thickness of 2000 nm and 4000 nm. The reflection rate in Comparative Example has a difference of ±50% or more with respect to a reflection rate of 0.35 for a bulk silicon.

Therefore, when the position control is implemented on the SOI wafer having the buried insulator layer thickness not satisfying (1/2)×(λ/n)×A, the variation in the reflection rate increases with respect to a position in a plane of the SOI layer when there is thickness distribution in the plane of the SOI layer, and the error of the position control is compounded.

The result of the reflection rate for SOI wafers having the same BOX layer thickness as Comparative Example and an SOI layer thickness of 4000 nm or more is given in FIG. 4. Referring to FIG. 4, it can be seen that the reflection rate varies by approximately ±10% in the range up to an SOI layer thickness of approximately 7000 nm. Accordingly, the designing method and the manufacturing method of the present invention are greatly useful under conditions of Example, particularly in the range up to an SOI layer thickness of approximately 7000 nm.

## Claims

1. A method for manufacturing an SOI wafer having an SOI layer formed on a buried insulator layer, the SOI wafer being to be used in a device fabrication process or an inspection process including a process of controlling a position of the SOI wafer on the basis of intensity of reflected light from the SOI wafer when the SOI wafer is irradiated with light having a wavelength λ, the method comprising the steps of: setting the wavelength λ to be used for controlling the position of the SOI wafer, designing a thickness of the buried insulator layer of the SOI wafer, on the basis of said wavelength λ of the light for use in the process of controlling the position, by an expression d=(1/2)×(λ/n)×A, wherein d represents the thickness of the buried insulator layer, n represents a refractive index of the buried insulator layer, and A represents an arbitrary positive integer, the process being to be implemented on the SOI wafer after manufacturing; and
fabricating the SOI wafer having the SOI layer formed on the buried insulator layer having the designed thickness.

2. The method for manufacturing an SOI wafer according to claim 1, wherein the buried insulator layer is any one of a silicon oxide film, a silicon nitride film, and a silicon oxynitride film, or a laminated insulator layer formed as a multilayer thereof.

3. The method for manufacturing an SOI wafer according to claim 1 or 2, wherein visible light is used as the light with which the SOI wafer is irradiated.

## Patentansprüche

1. Verfahren zur Herstellung eines SOI-Wafers mit einer auf einer verborgenen Isolationsschicht ausgebildeten SOI-Schicht, wobei der SOI-Wafer in einem Geräteherstellungsverfahren oder einem Untersuchungsverfahren verwendet wird, das ein Verfahren zur Steuerung einer Position des SOI-Wafers auf Basis der Intensität von reflektiertem Licht von dem SOI-Wafer einschließt, wenn der SOI-Wafer mit Licht einer Wellenlänge λ bestrahlt wird, wobei das Verfahren die Schritte umfasst aus: Einstellung der zur Kontrolle der Position des SOI-Wafers verwendeten Wellenlänge, Bestimmung einer Dicke der verborgenen Isolationsschicht des SOI-Wafers, auf der Basis der Wellenlänge λ des in dem Verfahren zur Kontrolle der Position eingesetzten Lichtes, mittels eines Ausdrucks d=(1/2)×(λ/n)×A, worin d die Dicke der verborgenen Isolationsschicht angibt, n steht für einen Brechungsindex der verborgenen Isolationsschicht und A steht für eine willkürliche positive Ganzzahl, wobei das Verfahren auf den SOI-Wafer nach der Herstellung angewendet wird; und Herstellung des SOI-Wafers mit der auf der verborgenen Isolationsschicht ausgebildeten SOI-Schicht mit der bestimmten Dicke.

2. Verfahren zur Herstellung eines SOI-Wafers nach Anspruch 1, worin die verborgene Isolationsschicht eine beliebige ist aus Siliziumoxidfilm, Siliziumnitridfilm und einem Siliziumoxinitridfilm, oder eine laminierte Isolationsschicht gebildet als Multischicht davon.

3. Verfahren zur Herstellung eines SOI-Wafer nach Anspruch 1 oder 2, worin sichtbares Licht als Licht, mit dem der SOI-Wafer bestrahlt wird, verwendet wird.

## Revendications

1. Procédé de fabrication d'une plaquette de SOI ayant une couche de SOI formée sur une couche isolante enterrée, la plaquette de SOI devant être utilisée dans un procédé de fabrication de dispositif ou un procédé d'inspection comprenant un processus de contrôle d'une position de la plaquette de SOI sur la base de l'intensité de lumière réfléchie provenant de la plaquette de SOI lorsque la plaquette de SOI est irradiée avec une lumière ayant une longueur d'onde λ, le procédé comprenant les étapes de :
réglage de la longueur d'onde λ à utiliser pour contrôler la position de la plaquette de SOI,
conception d'une épaisseur de la couche isolante enterrée de la plaquette de SOI, sur la base de ladite longueur d'onde λ, de la lumière à utiliser dans le processus de contrôle de la position ; par une expression d = (1/2) x (λ/n) x A, dans laquelle d représente l'épaisseur de la couche isolante enterrée, n représente un indice de réfraction de la couche isolante enterrée, et A représente un nombre entier positif arbitraire, le processus devant être mis en oeuvre sur la plaquette de SOI après la fabrication ; et
fabrication de la plaquette de SOI ayant la couche de SOI formée sur la couche isolante enterrée ayant l'épaisseur conçue.

2. Procédé de fabrication d'une plaquette de SOI selon la revendication 1, dans lequel la couche isolante enterrée est l'une quelconque parmi un film d'oxyde de silicium, un film de nitrure de silicium et un film d'oxynitrure de silicium, ou une couche isolante stratifiée formée sous forme d'une multicouche de celle-ci.

3. Procédé de fabrication d'une plaquette de SOI selon la revendication 1 ou 2, dans lequel la lumière visible est utilisée comme lumière avec laquelle la plaquette de SOI est irradiée.
